# EUROPÄISCHE PATENTANMELDUNG

(11) **EP 1 791 184 A1**
(43) Veröffentlichungstag der Anmeldung: **30.05.2007**
(21) Anmeldenummer: 05405676.7
(22) Anmeldetag: 29.11.2005
(51) Int. Cl.: H01L 31/042

(54) **Solaranlage sowie Verfahren zum Betrieb**

(71) Anmelder: Dr. H. Frauenknecht GmbH, 6403 Küssnacht am Rigi (CH)
(72) Erfinder: Die Erfindernennung liegt noch nicht vor
(74) Vertreter: Wächter, Roland

(57) **Zusammenfassung**

Eine Solaranlage mit einem Solarpanel (1) besteht aus mehreren zueinander über Luftspalte (17) beabstandeten Modulen (11-14). Die Module sind in einem Rahmen (10) eingesetzt, welcher mit einem Support (15) verbunden ist. Am Support (15) greift ein elektrischer Antrieb (5) an, welcher diesen und damit das ganze Panel (1) zeitabhängig zur maximalen Sonneneinstrahlung um eine feststehende Achse (6) verschwenkt. Die Speisung des Antriebs (5) erfolgt autonom; dadurch entfallen solare Sensoren sowie Hilfsenergie. Der Aufbau der Module (11-14) erlaubt einen Druckausgleich zwischen der Ober- und Unterseite des Panels (1) über Luftspalte (17), so dass ein ordentlicher Betrieb auch bei starken Böen und ohne Gefährdung der Umwelt möglich ist. Ein Betriebsverfahren ist auf einen minimalen Energiekonsum ausgerichtet. Die Solaranlage findet insbesondere für Notstromversorgungen sensitiver Infrastrukturen Verwendung.

## Beschreibung

Die vorliegende Erfindung bezieht sich auf eine Solaranlage gemäss dem Oberbegriff des Anspruchs 1 sowie auf ein Verfahren zu dessen Betrieb nach Anspruch 17.

Es ist ein Rohrmotor bekannt (WO -A1- 98/49464), welcher für Solaranlagen (System Poulek, CZ) eingesetzt ist. Der Rohrmotor wird in einem Winkel von 30° bis 60° schräg gestellt und in Nord/Süd Richtung ausgerichtet. Darauf montiert sind an Querträgern aneinander anschliessende Solarmodule (Solarzellen), welche der Energiegewinnung dienen. Zusätzlich ist am unteren Ende des Rohrmotors in etwa senkrecht zu den Solarkollektoren eine kleinere, doppelseitige Sensorzelle (= zwei rückseitig aneinander liegende Solarmodule) von je zirka 0,06 bis 0,08 m² Fläche angebracht, welche der Feststellung des Sonnenstands und der Speisung des Rohrantriebs dient. Zwischen den beiden Seiten der Zelle bildet sich eine Differenzspannung, welche den Motor für das "Tracking" antreibt. Nachteilig ist dabei, dass nur bei einer intensiven direkten Sonnenbestrahlung genügend Energie für den Rohrmotor zur Verfügung steht. Unter einem bedeckten Himmel ist ein Nachführen (Schwenken; Kippen) des Solarpanels in die Richtung des Strahlungsmaximums wegen der auftretenden diffusen Strahlung nicht möglich. Abends ist das Panel nach Westen gekippt und stellt sich erst im Laufe des Vormittags gegen Osten ein, dies erst wenn eine genügend hohe Differenzspannung von der Sensorzelle abgegeben wird. Die Praxis zeigt ferner, dass Reflexionen von anderen Bauten und Dächern, ebenso von anderen Solaranlagen zu Fehleinstellungen des Solarpanels führen können. Der jährlich erzielte solare Ertrag dieses Solarpanels ist daher gegenüber stationären Anlagen nur wenig höher, dies trotz beträchtlichem technischen Mehraufwand. Zudem ist die gesamte Anlage sturmgefährdet, bildet das Panel doch gerade im gekippten Zustand eine grosse Angriffsfläche für Winde und kann insbesondere starken Böen nicht standhalten.

Generell haben Solarpanel in der Solartechnik bisher eine nur geringe Verbreitung gefunden, nicht zuletzt deshalb, weil am Solarpanel auftretenden Windkräfte bisher nur mit aufwendigen Konstruktionen und Verankerungen beherrschbar waren.

Es ist daher Aufgabe der Erfindung eine Solaranlage zu schaffen, die betriebssicher ist und mit wirtschaftlich vertretbarem Aufwand gegenüber stationären Solaranlagen einen erheblich höheren Ertrag abgibt. Insbesondere soll die tägliche Sonnenscheindauer besser genutzt werden. So soll die Anlage auch in den frühen Morgenstunden und bis zum Sonnenuntergang elektrische Energie liefern. Insbesondere muss bei diffuser Strahlung ein maximaler solarer Ertrag erzielbar sein. Die Anlage muss wetterfest aufgebaut sein, d.h. sie soll bei allen auf einem Hausdach auftretenden Temperaturen und extremen Windverhältnissen (Stürmen) funktionsfähig bleiben; sie muss auch starken Böen und Schneelasten unbeschadet Stand halten. Es sollen deshalb in der Anlage Vorkehrungen getroffen werden, um die bei einem gegen den Wind gedrehten Solarpanel die auf die mechanische Konstruktion der Anlage wirkenden Kräfte zu reduzieren. Ebenfalls soll die Bildung einer zusammenhängenden Schneedecke auf der Oberfläche des Solarpanels verhindert werden.

Diese Aufgabe wird durch die Merkmale der Patentansprüche gelöst.

Gemäss Anspruch 1 wird die Energie zum Antrieb des Verstellmotors direkt einer Leistungszelle (d.i. ein Solarmodul) entnommen, wodurch Fremdeinspeisungen jeglicher Art entfallen. Damit steht zu jeder Zeit am Tage ausreichend Energie zum Kippen sämtlicher Module auf einer Drehachse zur Verfügung, ohne die Leistungsbilanz des angeschlossenen Solarmoduls spürbar zu beeinträchtigen. Ebenfalls sind Speicherbatterien, deren elektrische Leistung bekanntlich temperaturabhängig ist, nicht erforderlich.

Nach dem Verfahren nach Anspruch 17 wird eine optimale energiesparende Ansteuerung eines Antriebs für Solaranlagen erreicht. Der dafür notwendige Energiekonsum ist sehr gering; er entspricht demjenigen einer momentanen Abschattung eines einzigen Moduls durch eine vorüberziehende Wolke.

In weiteren abhängigen Ansprüchen sind technische Weiterbildungen des Erfindungsgenstands beschrieben, welche diesen optimieren:

Besonders effizient und kostengünstig ist eine Steuerung der Schwenkbewegung des Solarpanels der Anlage in einzelnen, vorgegebenen Schritten oder mit einer kontinuierlichen Drehbewegung, entsprechend dem zu erwartenden täglichen Sonnenstand. Dies erübrigt Sensorzellen und dgl. sowie entsprechende Regelkreise und ermöglicht störungsfrei arbeitende Anlagen. Vergleiche Anspruch 2.

Besonders effizient ist eine diskontinuierliche Steuerung nach vorgegebenen Winkelstellungen. Auf Grund der hohen Strahlungsempfindlichkeit moderner Solarmodule entsteht keine messbare Leistungseinbusse gegenüber einer kontinuierlichen Verstellung.

Die Ausgestaltung von Luftspalten zwischen einzelnen Solarmodulen nach Anspruch 3 oder 4 verhindert bei deren Anströmung (Wind, Böen) einen "Tragflügeleffekt". Bereits ein Spalt von mehr als 15 mm ergibt einen ausreichenden Druckausgleich (Entlastung) zwischen der Unter- und der Oberseite des ganzen Solarpanels. Bei Schneefall kann sich auf dem Panel keine zusammenhängende Schneedecke bilden, so dass die Verminderung der elektrischen Leistung durch Schneeablagerungen gegenüber zusammenbauten Solarmodulen geringer und/oder nur von kürzerer Dauer ist.

Die Lagerung der Solarmodule auf der Breitseite eines U-Profils erlaubt deren einfache und sichere Halterung und bietet gleichzeitig Platz zum Einbau von Lagerklötzen, welche die Drehachse der Anlage aufnehmen. Siehe Anspruch 5.

Nach Anspruch 6 erfolgt das Kippen des Solarpanels um die eine Drehachse bildende Welle, was das Abdichten der Lager zumindest vereinfacht. Zudem lässt sich dadurch leicht eine sich über die Mittelachse erstreckende Fläche, als Auflage für die Solarmodule, bilden. Dadurch entstehen - gegenüber einem Antrieb mit einem Rohrmotor - ein kleineres polares Massenträgheitsmoment sowie geringere Unwuchten durch Asymmetrien.

Die zentrische Lagerung der Solarpanels wird durch die Ausgestaltung des Trägers in Verbindung mit einem seitlichen Rahmen, entsprechend Anspruch 7, wesentlich erleichtert.

Ein gemäss Anspruch 8 installierter Federstab stellt das ungebremste Solarpanel selbständig in seine horizontale Null-Lage. Dies vereinfacht den Steuerungsvorgang und erhöht die Systemsicherheit, lässt sich doch dadurch das Panel auf einfachste Weise in seine nächtliche Ruhelage bringen. Diese kann zusätzlich vor aufziehenden orkanartigen Stürmen in gleicher Weise auch tagsüber eingestellt werden. Es sind auch mehrere Federstäbe unterschiedlicher Dimensionen denkbar, die unterhalb des Solarpanels angebracht eine objektspezifische Federkennlinie ergeben.

Das durch diese Art von "Biegestab" vom Antrieb aufzubringende grössere Drehmoment lässt sich durch eine Optimierung des Antriebs (Getriebeverhältnis und Motordrehzahl) problemlos erreichen.

Durch eine intervallweise Zuschaltung des Antriebs nach Anspruch 9 wird der Energiebedarf für die optimale Einstellung des Solarpanels minimiert. Kleinere Winkelfehler von beispielsweise 7.5° gegenüber der effektiven Sonneneinstrahlung wirken sich lediglich in der Grössenordnung von zirka 1 % Leistungsminderung aus.- Diese Art der Ansteuerung reduziert den technischen Aufwand und den Strombedarf gegenüber einer kontinuierlichen Nachführung beträchtlich.

Die Systemsicherheit und eine nochmals reduzierte Belastung der einzelnen Solarmodule ist durch den verteilten Energiebezug nach Anspruch 10 gegeben.

Eine nach Anspruch 11 ausgestaltete Hohlwelle wirkt sich gewichtsvermindernd aus, ohne dass Stabilitätsverluste entstehen, was insbesondere bei Montagen auf Dächern von grosser Bedeutung ist.

Besonders einfach und servicefreundlich ist die Kraftübertragung des Antriebs mittels eines Zahnkranzes gemäss Anspruch 12, der vorzugsweise im Bereich des oberen Endes der Drehachse angeordnet wird.

Die Schaltwippe gemäss Anspruch 13 erlaubt eine rasche und energiesparende Rückstellung eines ausgeschwenkten Solarpanels in seine horizontale Ruhelage.

Bewährt hat sich zur Betätigung der Schaltwippe ein kurzzeitig einschaltbarer Schaltmagnet nach Anspruch 14.

Obwohl die Schwenkbewegung des Panels ein hohes Untersetzungsverhältnis zwischen Motor und Zahnradsegment erfordert, empfiehlt sich ein Stirnradgetriebe nach Anspruch 15, aufgrund dessen guten mechanischen Wirkungsgrades.

Insbesondere bei grossen Solaranlagen mit mehreren gleichartigen Panels kann der wirtschaftliche Aufwand massiv reduziert werden, wenn diese miteinander gekoppelt sind. Anspruch 16. Als mechanische Treibmittel eignen sich Zahnriemen, Ketten oder Gestänge. Ebenfalls bieten sich moderne Funkübertragungssysteme (WLAN) an, welche eine kostengünstige elektrische Synchronisierung der einzelnen Antriebe ermöglichen.

Das Betriebsverfahren nach Anspruch 17 erweist sich als besonders vorteilhaft durch die Möglichkeit einer zeitweilig kontinuierlichen Zuschaltung der Solarenergie auf den Getriebemotor. Damit entsteht eine Ausrichtung des Panels in Richtung Osten, bereits während der morgendlichen Dämmerung. So werden bereits die frühen Morgenstunden optimal zur Energiegewinnung genutzt.

Besonders einfach und günstig ist der Einbau von Positionsmeldern gemäss Anspruch 18. Diese sind mit Vorteil am Zahnradsegment installiert, welches den Support mit den Solarmodulen trägt und dreht.

Von grosser Bedeutung ist die effiziente Speicherung der Schaltenergie zum Auskuppeln des Antriebs nach Anspruch 19. Dadurch stellt sich das Solarpanel - durch seinen Federstab - in die Ruhestellung und kann bereits am frühen Morgen diffuses Licht empfangen und den Kippvorgang in östlicher Richtung steuern. Die hierfür notwendigen Kräfte lassen sich mittels zusätzlicher Federn abstimmen, so dass auch in beliebigen Winkellagen ein starker Windstoss das Ausklinken in die Ruhestellung bewirken kann.

Optimal ist eine Aufladung des Kondensators über eine Sperrdiode, Anspruch 20, weil dadurch der Kondensator bis in die Nacht hinein die maximale Klemmenspannung zur Verfügung stellt.

Die Verwendung der Anlage in Verbindung mit Notstrom-Installationen (Anspruch 21) erhöht die Sicherheit von sensitiven Infrastrukturen, ohne dass eine Wartung der Anlage notwendig ist.

Nachfolgend werden an Hand von Zeichnungen Ausführungsbeispiele der Erfindung erläutert, wobei für gleiche Funktionsteile gleiche Bezugsziffern verwendet sind.

Es zeigen
- Fig. 1: eine an einer Ecke eines Flachdachhauses installierte Solaranlage mit schwenkbarem Panel und unten angeordneter Antriebseinheit,
- Fig. 2: die Bauelemente der Antriebseinheit Fig. 1 mit abgenommener Schutzhaube in Draufsicht,
- Fig. 3: die Antriebseinheit Fig. 2 von der Seite betrachtet,
- Fig. 4: ein unteres Dreibein als Lagerung für eine feststehende Welle mit drehendem Solarpanel, über Zahnriemen gekoppelt mit benachbarten Anlagen,
- Fig. 5: eine Prinzipdarstellung einer Notstromversorgung mit Netzrückspeisung mit drei Solarpanels und einer Antriebseinheit,
- Fig. 6: ein vereinfachtes Ablaufdiagramm zur Steuerung der Solarpanels nach Fig. 5, mit charakteristischen Steuersignalen Sx,
- Fig. 7: eine drahtlose Übertragungsstrecke zur Abgabe der Steuersignale Sx gemäss Fig. 6 an die Solarpanel,
- Fig. 8: das Blockschaltbild einer alternativen, in die Antriebseinheit integrierten autonomen Steuerung,
- Fig. 9a-c: den zeitlichen Ablauf der Steuersignale für die Steuerung nach Fig. 8, in Abhängigkeit der Jahreszeiten, und
- Fig. 10: zwei schräggestellte, mechanisch gekoppelte Solaranlagen mit einer einzigen Antriebseinheit.

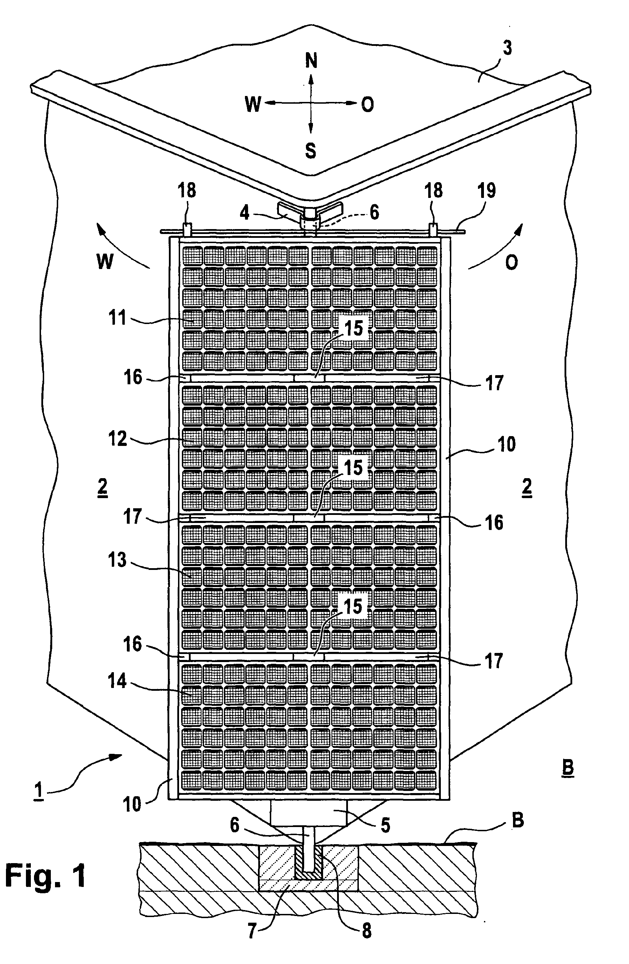

In Fig.1 ist mit 1 ein Solarpanel bezeichnet, welches an der Ecke von zwei unter einem Winkel von 90° aufeinander stossenden Hauswänden 2 plaziert ist. Das Solarpanel 1 ist im wesentlichen durch vier Solarmodule 11-14 gebildet, welche in einem Rahmen 10 aus einem U-Profil zusammengefasst und fixiert sind. Ein Flachdach 3 ist in üblicher Weise ausgestaltet; das Haus ist in seiner Diagonale in Nord/Süd-Richtung ausgerichtet. Im oberen Teil der Hausecke ist eine Befestigung 4 für eine feststehende Welle 6 angebracht, welche in einer Lagerbüchse 8 gefasst und in Zementguss 7 im Betonfundament B einzementiert ist. Unterhalb des Solarpanels 1 befindet sich ein elektrischer Antrieb 5, der mechanisch mit einem zentralen Support 15 verbunden ist. Zwischen den einzelnen Solarmodulen 11-14 sind Distanzhalter 16, so dass zwischen den Modulen Luftspalte 17 gebildet sind, welche dem Druckausgleich bei Windbelastung dienen und gleichzeitig die Bildung einer zusammenhängenden Schneedecke verhindern. Oberhalb des Solarpanels 1 ragen zwei Führungsklötze 18 heraus, durch welche ein an der Welle 6 befestigter Federstab 19 geführt ist, der als Rückstellfeder für das ganze Panel 1 dient. Beide Teile 16 und 18 bestehen aus einem UV-beständigem Polymer.

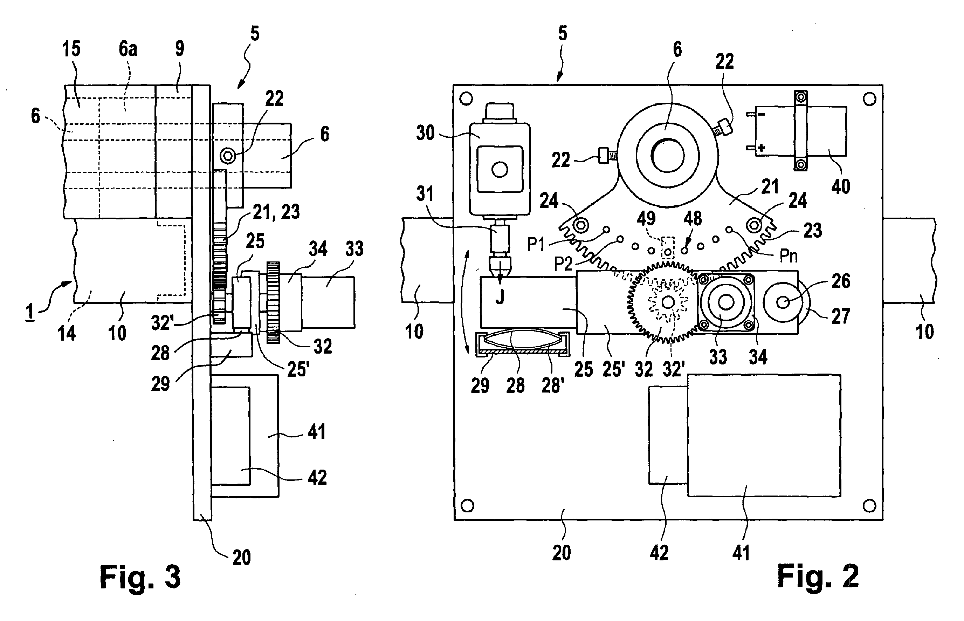

Gemäss Fig. 2 ist der elektrische Antrieb 5 als autonome Einheit auf einer Grundplatte 20 aufgebaut. Durch die Grundplatte 20 ist das Ende der als Hohlwelle ausgestalteten Welle 6 geführt, die mit einem Zahnradsegment 21 bestückt ist. Die Lage des Zahnradsegments 21 lässt sich durch Feststellschrauben 22 in seiner Winkellage justieren. Im Zahnradsegment 21 sind Positionsgeber eingelassen, die als Magnetstäbe 48 ausgebildet über einen Positionssensor 49 Positionssignale P1-Pn erzeugen. Auf dem Zahnradsegment 21 ragen endseitig Zapfen heraus, die der mechanischen Wegbegrenzung 24 dienen. Somit kann das Solarpanel 1, Fig. 1, um max. 90° verschwenkt werden. Eine Schaltwippe 25, 25' ist auf Lagerstellen 26, 27 endseitig drehbar geführt. Sie dient als Träger für einen Getriebemotor 33 mit Getriebe 34 und Zwischenrädern 32, 32', welche eine Drehzahluntersetzung bilden und wobei das Zahnrad 32' (Ritzel) in die Verzahnung 23 des Zahnradsegmentes 21 eingreift.

Gehalten ist die Wippe 25 untenseitig durch Blattfedern 28, 28', welche in einem Federgehäuse 29 gelagert sind. Auf der Oberseite der Schaltwippe 25 liegt ein Stössel 31 auf, der Bestandteil des Ankers eines Schaltmagneten 30 ist. Auf der rechten oberen Seite der Grundplatte 20 ist ein Speicherkondensator 40 befestigt, welcher zur Ansteuerung des Schaltmagneten 30 vorgesehen ist. Im unteren Teil der Platte 20 ist eine elektronische Steuerung 41 angeordnet, über deren Anschlusskasten 42 eine hier aus Übersichtlichkeitsgründen nicht dargestellte Verkabelung angeschlossen ist. Seitlich zur Grundplatte 20 ist der Rahmen 10 ersichtlich, mit dem diese kraftschlüssig verbunden ist.

Von der Seite betrachtet erkennt man die Bestandteile der Fig. 2 in Fig. 3 in ihrer Tiefe. Ersichtlich ist hier wiederum der Rahmen 10, der mit seinem U-Profil die Solarmodule umschliesst. Ebenfalls erkennt man das durchgehende Hohlprofil der Welle 6 im Support 15 sowie den zugehörigen Träger 9 (Endflansch) für den Rahmen 10. Ein Lager 6a besteht aus einem gleitfähigen Polymer (Delrin, Handelsmarke der Firma Dupont, USA).- Im Betriebszustand ist die hier in einer Servicestellung befindliche Antriebseinheit um 180° gedreht, d.h. das gestrichelt eingezeichnete Solarmodul 14 befindet sich oben.

Aus den Fig. 1 bis 3 ergibt sich, dass der in Gang gesetzte Getriebemotor 33 das ganze Antriebssystem 5 mit dem Support 15, dem Rahmen 10 und den Modulen 11-14 um die Welle 6 dreht bzw. schwenken kann.

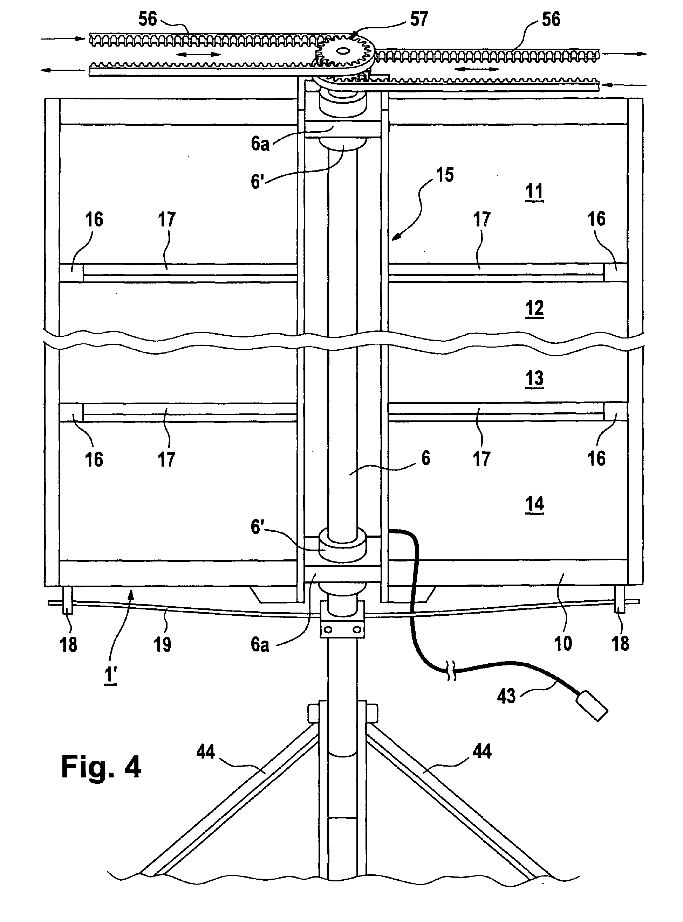

Eine Variante eines Solarpanels 1', im Verbund mit weiteren Panels 1' ist in Fig. 4 dargestellt. Die Welle 6 ist unter einem Elevationswinkel von 45° gegen Süden gerichtet. Gegenüber Fig. 1 bis 3 ist hier speziell eine Gleitbüchse 6' vorgesehen, welche die Welle 6 verstärkt und deren Durchbiegung reduziert. Am oberen Ende der Welle 6 sind zwei Antriebsräder 57 für Zahnriemen 56 angeordnet; eine Antriebseinheit 5 befindet sich in dieser Version auf einer Welle 6 einer benachbarten Anlage. Dadurch ist leicht ein Synchronlauf von zueinander parallelen Anlagen mit minimalem technischen Aufwand möglich. Ersichtlich ist in dieser Figur zudem ein Anschlusskabel 43, ein genormtes, sogenanntes Solarkabel mit Stecker.

Die Zahnriemen 56 lassen sich auch durch gebogen ausgestaltete Gestänge ersetzen, was insbesondere in Gegenden, wo keine Vereisungsgefahr besteht, vorteilhaft sein kann.

Alternativ ist, hier nicht dargestellt, an einem separaten Antrieb 5, der isoliert aufgestellt ist, ein weiteres Antriebsrad 57 vorgesehen, mit dem die einzelnen Panels 1', 1" über die Zahnriemen 56 angetrieben werden.

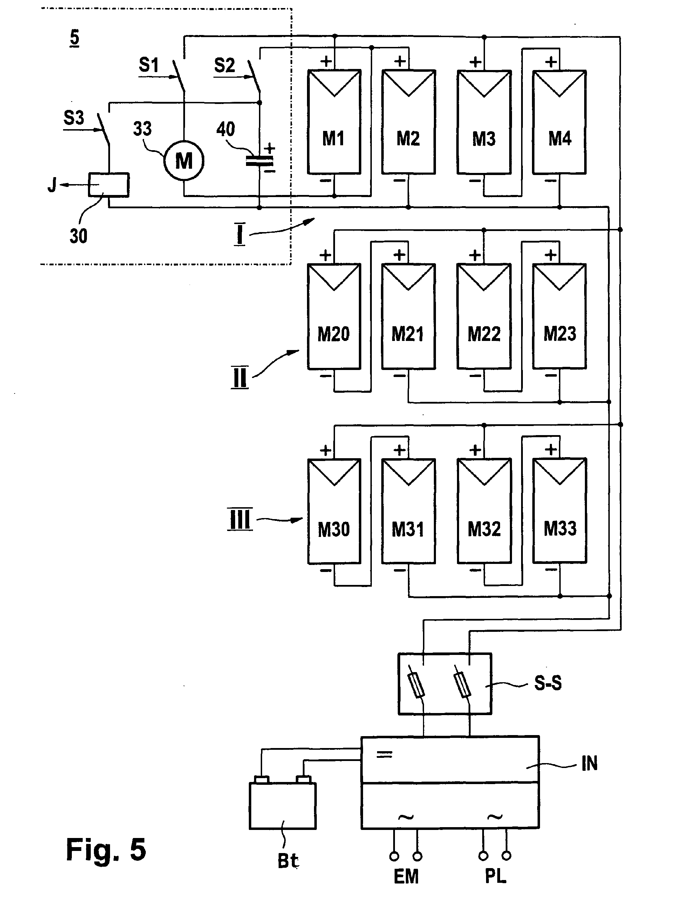

Nach Fig. 5 verwendet eine Notstromversorgung mit Rückspeisung ins Stromnetz drei zueinander parallel geschaltete kippbare Solarpanels (Solarpanel) I-III. Eingesetzt ist hierfür ein handelsüblicher Inverter IN (Sun Profi Emergency, SP 1500 E der Firma Sun Power Solartechnik GmbH, D-61118 Bad Vilbel). Dieser lädt Batterien Bt (Gleichspannung) und speist ins Stromnetz die laufend gewonnene Solarleistung in Form einer einphasigen Wechselspannung ein. Der zugehörige Netzanschluss ist mit PL (Power Line) bezeichnet. Der zweite Ausgang EM (Emergency) des Inverters IN gibt unverzüglich eine Spannung ab, wenn das Stromnetz ausfällt. Die Speisung erfolgt dann durch die Batterien Bt, welche tagsüber nachgeladen werden. Zwischen den Solarmodulen M1 bis M33 der Panels I-III und dem Inverter IN ist ein Trennschalter S-S mit integrierten Sicherungen geschaltet.

Für diese Anwendung genügt wiederum eine einzige elektrische Antriebseinheit 5 für die Schwenkbewegung der Panels I-III. Der Getriebemotor 33 wird über einen Schalter durch ein Signal S1 kurzzeitig an ein oberes Solarmodul M1 angeschlossen, was zu einer Schwenkbewegung um beispielsweise 7.5 Winkelgrade führt. Ebenfalls wird während eines kurzen Intervalls durch ein Steuersignal S2 ein weiteres Modul M2 an den Speicherkondensator 40 angeschlossen und dieser mit der vollen Spannung von beispielsweise 45 V geladen. Durch ein Steuersignal S3 kann zu gegebener Zeit mit der im Kondensator 40 gespeicherten Energie der Schaltmagnet 30 betätigt werden.

Daraus ergibt sich eine äusserst einfache zeitgerechte Steuerung der Schwenkbewegung: Durch das Steuersignal S1 werden die Panels I-III jeweils um 7.5° bewegt, solange die Sonne genügend Energie abgibt. Bleibt diese für eine längere Zeit aus, oder sind - im Normalfall abends - die Panels in ihre westliche Endlage gekippt, so wird der Schaltmagnet 30 durch das Steuersignal S3 betätigt, was einen mechanischen Impuls J auf die Schaltwippe 25, 25' ergibt und den Kondensator 40 entlädt, siehe Fig. 2. Dadurch wird das Zwischenrad 32' vom Zahnradsegment 21 abgehoben, so dass die Rückstellfeder 19, Fig. 1; Fig. 4 die Panels I-III in ihre horizontale Null-Lage dreht. Anschliessend schwenkt die Schaltwippe 25,25', durch die Blattfeder 28,28' betätigt, nach oben und klinkt das Zahnrad 32' wieder in die Verzahnung 23 ein. Somit können die einzelnen durch die Positionsgeber P1-Pn vorgegebenen Schwenkwinkel zeitlich vorbestimmt angefahren werden.

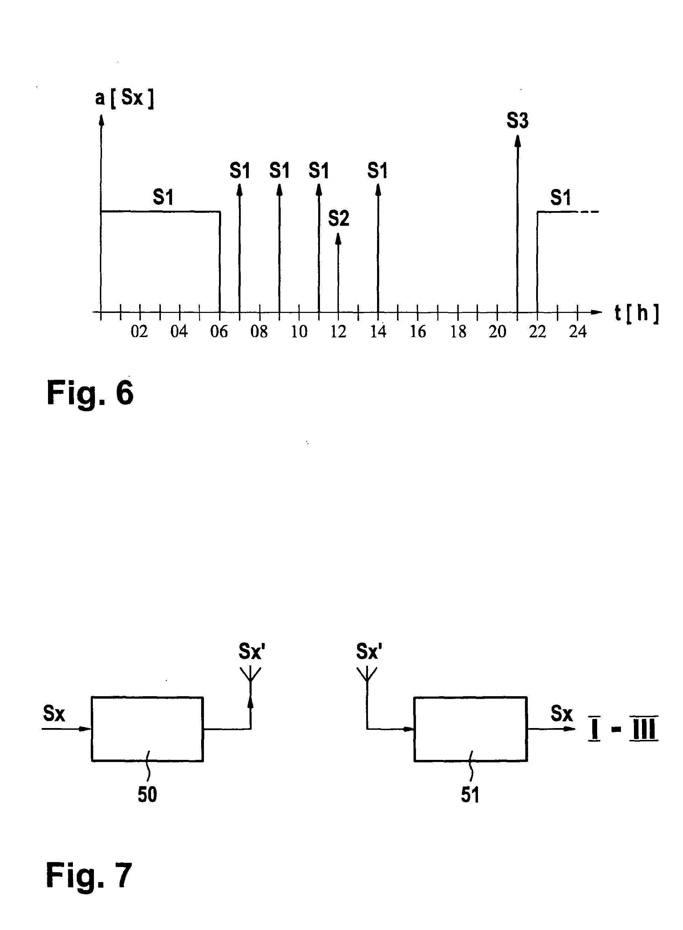

Diese Art der zeitabhängigen Steuerung erlaubt eine volle Berücksichtigung des Sonnenstands, ohne dass solare Sensoren nötig sind. Dies ist im charakteristischen Ablauf beispielhaft in Fig. 6 dargestellt, wo die Aktion a als Funktion der Zeit t im Tagesablauf durch die Signale S1-S3 eingezeichnet ist.

Dabei bedeuten:
S1 = Steuersignal für Getriebemotor 33 (Schwenkbewegung)
S2 = Steuersignal zur Ladung des Elektrolytkondensators 40
S3 = Steuersignal zur Auskupplung des Getriebes (auf Schaltwippe 25, 25'), was zu einer Rückstellung R in die Null-Lage 0. führt.

Eine Möglichkeit zur Signalübertragung von einem sogenannten Master (Steuereinheit) auf "Slaves" ist durch die Übertragungsstrecke nach Fig. 7 aufgezeigt. Ein Sender 50 (WLAN) transformiert ein Steuersignal Sx nach Fig. 6 in ein Sendesignal Sx'; dieses wird im Empfänger 51 wiederum zum Signal Sx transformiert und den Panels I und/oder I-III zugeführt. Die Kopplung zwischen den Panels I-III kann somit mechanisch oder elektrisch erfolgen.

Eine hochfrequente Signalübertragung lässt sich mit günstigen Komponenten und notorisch bekannten Verfahren der mobilen Computertechnik (z.B. Bluetooth) auch für grosse solare Installationen leicht realisieren und entsprechend elektrisch versorgen, dies ohne spürbare Einbussen in der solaren Leistungsbilanz.

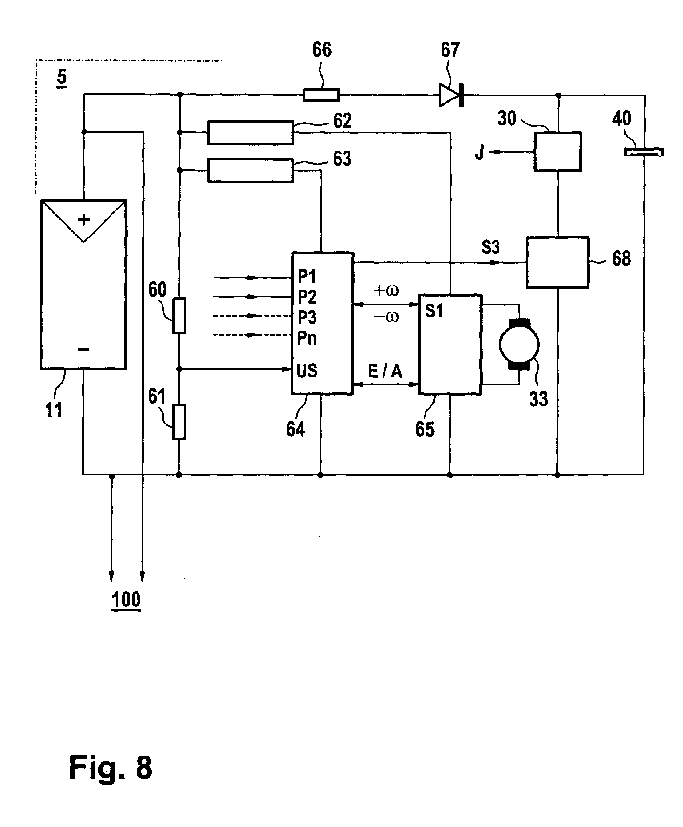

In einem bevorzugten Ausführungsbeispiel, Fig. 8, erhält eine Antriebseinheit 5 ihre Energie von einem einzigen Solarmodul 11. Über einen Spannungsregler 62 und eine Brückenschaltung 65 wird der Getriebemotor 33 gespeist. Die Speisung eines Mikroprozessors 64 erfolgt über einen Spannungsregler 63. Mit dem Abgriff einer am Modul 11 angeschlossenen Widerstandsbrücke 60,61 ist der Schwellenwerteingang US des Mikroprozessors 64 verbunden und schaltet diesen bei einer genügend hohen Eingangsspannung, beispielsweise 38 V in seinen Funktionszustand.

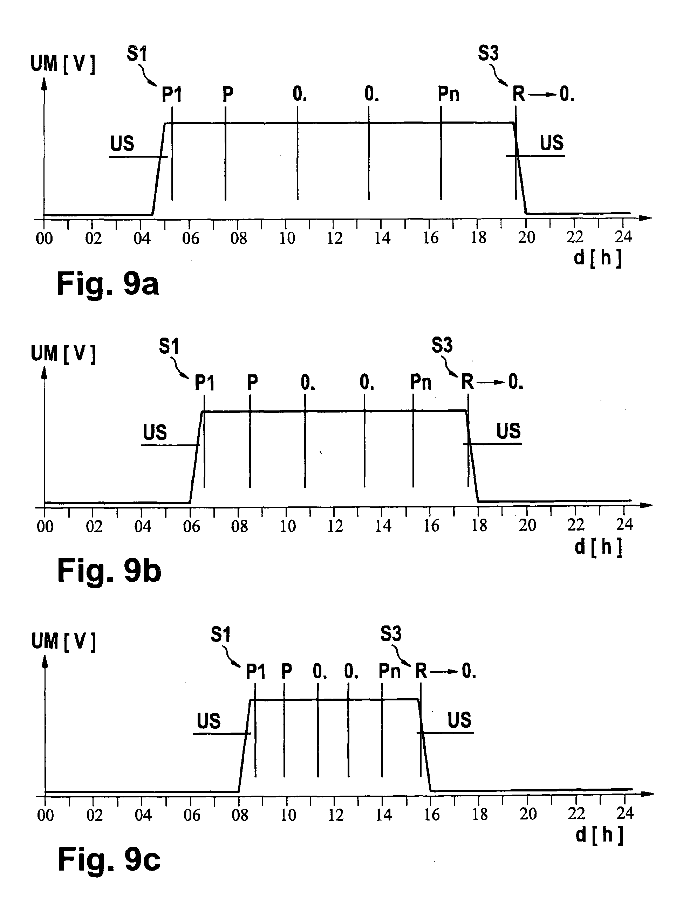

Dies ist aus den Diagrammen Fig. 9a-9c ersichtlich, wobei Fig. 9a die Klemmenspannung UM am Modul in einer typischen Sommerphase, Fig. 9b den Spannungsverlauf UM im Frühjahr oder Herbst und Fig. 9c eine typische Winterphase darstellen.

Sobald die Schwellenwertspannung US erreicht ist, beginnt ein im Prozessor 64 enthaltener Zähler mit seiner Zählfunktion und stoppt bei einer Unterschreitung der Spannung US. Damit ist ein Tagesablauf mit seiner effektiven Sonnenscheindauer speicherbar; dies wird täglich wiederholt und aus den Messwerten von 8 Tagen ein Mittelwert gebildet, welcher der sequentiellen Aufteilung der Steuersignale in die Einzelschritte P1, P2 bis Pn dient. Ein Vergleich des Diagramms vom Sommer, Fig. 9a mit dem Winter, Fig. 9c zeigt, wie sich die Schrittlänge ändert. Damit ergibt sich eine automatische Adaption des Systems an die Jahreszeit, d.h. bei kürzerer Sonnenscheindauer erfolgt eine verbesserte Anpassung an die Einstrahlungsrichtung.

Die typischen Horizonalstellungen des Panels 1 bzw. 1' sind als Null-Lagen 0. bezeichnet; vgl. Fig. 9a-9c. Das Signal S3 bewirkt hier ebenfalls das vorgängig beschriebene Ausschwenken des Zahnrades 32' und dadurch die Rückstellung R des Panels in die Null-Lage 0. Danach rastet das Zahnrad 32' wieder ein; die Anlage ist nun bereit, schon beim Auftreten einer diffusen morgendlichen Dämmerung, beim wieder Erreichen der Schwellenwertspannung US, Steuersignale S1 abzugeben, um zuerst die Position P1 und dann in zeitlicher Folge die weiteren Positionen P2 bis Pn gemäss Fig. 9a-9c anzufahren.

Die Rückmeldung der Positionssignale P1 bis Pn ist am Mikroprozessor 64, Fig. 8, eingezeichnet; dadurch wird die Stromzufuhr zur Brückenschaltung 65 und zum Motor 33 unterbrochen, was in der Fig. 8 als E bzw. als A eingetragen ist. Die Drehrichtungsumkehr -Ω/+Ω erfolgt ebenfalls an diesem als Doppelbrücke ausgeführten Baustein 65.

Während in Fig. 5 von elektromagnetischen Schaltern (Relais) S1-S3 mit entsprechenden galvanischen Trennungen ausgegangen wurde, sind nach Fig. 8 Halbleiterelemente verwendet.

Die Ladung des Elektrolytkondensators 40, Fig. 8, erfolgt über einen seriellen Widerstand und eine Sperrdiode 67, d.h. eventuelle Leckströme im Kondensator 40 werden automatisch kompensiert. Das Steuersignal S3 ist vom Mikroprozessor 64 dem Schalteingang eines elektronischen Schalters 68 (CMOS FET) zugeführt, welcher den Schaltmagneten 30 ansteuert.

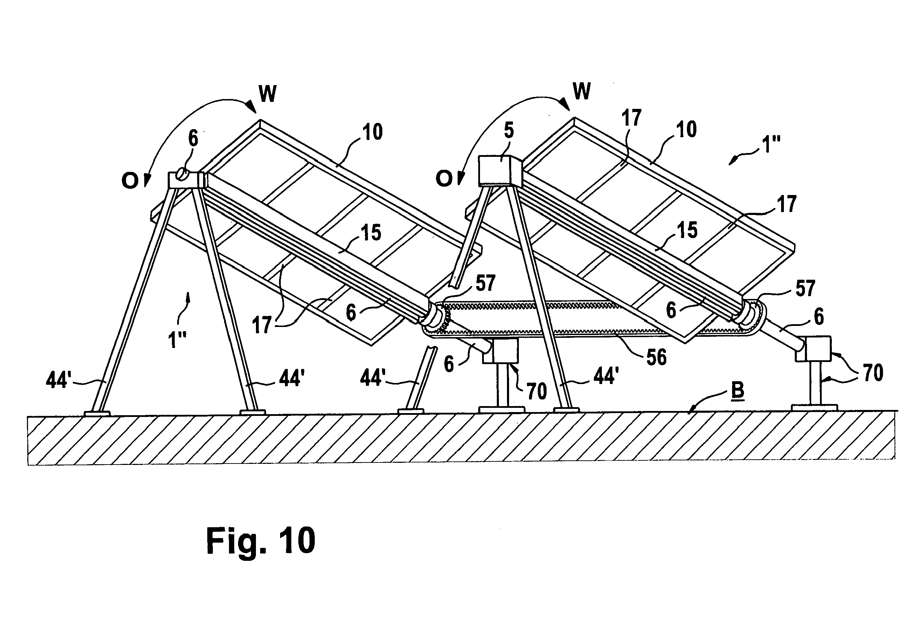

In Fig. 10 ist ein bevorzugtes Ausführungsbeispiel einer aus zwei Panels 1" bestehenden Anlage aufgezeigt, welche beide einen Elevationswinkel von 30° aufweisen. Die Wellen 6 der beiden Panels 1" sind wiederum in Stützen 44' sowie zusätzlich in einem niedrigen Ständer 70 fixiert. Das Ganze ist auf einem Beton-Flachdach eines Gebäudes aufgebaut. Ein einziger Antrieb 5 steuert autonom beide Panels 1". Die Kopplung über einen Zahnriemen 56 ist vereinfacht dargestellt, sie verläuft in Wirklichkeit in einem "Kettenkasten" und enthält an sich bekannte Spannglieder, um temperaturbedingte Dehnungen zu kompensieren.

In dieser Variante wurde auf eine Rückstellung mittels eines Federstabs 19 verzichtet; vgl. Fig. 1 und Fig. 4. Dies geschieht hier über den Antrieb 5 und die Zahnriemen 56. Eine Blockierung der Zahnriemen während der horizontalen Nullstellung, beispielsweise an den Spanngliedern, ergibt über die elastischen Riemen 56 ebenfalls eine angestrebte Federwirkung.

Eine derartige Anlage erlaubt je nach Art der Solarmodule leicht eine maximale Leistung Pp von 1600 W zu erzielen und kann der zuverlässigen Versorgungssicherheit von auch grossen Servern und/oder Kommunikationszentralen, auch im Dauer-Notstrombetrieb, dienen.

Der Kombinations- und Anpassungsmöglichkeit des Erfindungsgenstands sind nur wenige Grenzen gesetzt, erlaubt doch die autonome und leistungsmässig nicht ins Gewicht fallende Ausgestaltung der zeitgerechten Steuerung von optimierten Solaranlagen individuelle Anpassungen an spezifische Anwendungen und an die hierfür zum Einsatz gelangenden technischen Mittel.

Selbstverständlich kann die Anlage auch in der Elevation an die Sonnenstellung Winter/Sommer angepasst werden. Mit einem entsprechenden technischen Aufwand liesse sich der Erfindungsgenstand auch als zwei- oder dreidimensionale Nachführung ausführen, was aber aus wirtschaftlichen Gründen derzeit als unzweckmässig erscheint.

### Bezeichnungsliste

- 1,1',1": Solarpanel
- 2: Hauswände (90° zueinander)
- 3: Dachabdeckung (Flachdach)
- 4: obere Wellenbefestigung
- 5: El. Antrieb / Antriebseinheit
- 6: Welle / Hohlwelle (fix)
- 6': Gleitbüchse / Verstärkung Welle
- 6a: Lager / Lagerklotz (Nylon/Delrin)
- 7: Zementguss
- 8: Lagerbüchse
- 9: Endflansch / Träger
- 10: Rahmen (U-Profil)
- 11-14: Solarmodule
- 15: Support mit Lager (U-Profil)
- 16: Distanzhalter (Polymer)
- 17: Luftspalt
- 18: Führungsklötze mit Querbohrung für 19
- 19: Federstab / Rückstellfeder
- 20: Grundplatte von 5
- 21: Zahnrad / Zahnradsegment
- 22: Stellschrauben
- 23: Verzahnung
- 24: mech. Wegbegrenzungen

- 25,25': Schaltwippe / Träger
- 26,27: Lagerstelle von 25
- 28,28': Blattfedern
- 29: Federbett / Federgehäuse
- 30: Schaltmagnet
- 31: Stössel (Anker)
- 32: Zwischenrad (Zahnraduntersetzung)
- 32': kleines Zwischenrad / Antriebsritzel
- 33: Getriebemotor (12 V)
- 34: Getriebe
- 40: Elektrolytkondensator / Speicher
- 41: Steuerung (Elektronik)
- 42: Anschlusskasten zu 41
- 43: Anschlusskabel zu 14 (Solarkabel)
- 44,44': Stützen / Verstrebungen
- 48: Positionsgeber (Magnetstäbe)
- 49: Positionssensor (Reed-Schalter)
- 50: Sender (WLAN)
- 51: Empfänger (WLAN)
- 56: Zahnriemen
- 57: Antriebsräder
- 60,61: Widerstände (Brücke)
- 62: Spannungsregler Speisung von 33
- 63: Spannungsregler Speisung von 64
- 64: Mikroprozessor
- 65: Brückenschaltung Speisung 33
- 66: Widerstand (Strombegrenzung)
- 67: Sperrdiode
- 68: Leistungsschalter (CMOS FET)

- 70: Ständer

- 0.: Null-Lage (Panel waagrecht)
- I-III: Schwenkbare Panels (Solarpanel)

- A: Aus (Getriebemotor 33)
- a: Aktion
- B: Betonfundament / Betonplatte
- Bt: Batterien
- E: Ein (Getriebemotor 33)
- EM: Notstromversorgung (Emergency)
- IN: Inverter / Wechselrichter
- J: mech. Impuls
- M1-M33: Solar-Module
- PL: Netzeinspeisung (Powerline)
- Pp: Maximale Solarleistung (Peak)
- P1-Pn: Positionsgeber / Position (Stellung von 1)

- R: Rückstellung (von 1,1')
- Sx, Sx': Steuersignale
- S-S: Trennschalter mit integr. Sicherungen
- S1: Steuersignal Motor (Schwenkbewegung)
- S2: Steuersignal Kondensatorladung
- S3: Steuersignal Auskupplung Getriebe
- t: Zeit (h)
- UM: Klemmenspannung Modul
- US: Schwellenwertspannung
- V: Volt (Spannung)

- S: Süd
- O: Ost
- W: West

- Ω: Drehrichtung von 33
(+Ω = Vorlauf; -Ω = Rücklauf)

## Patentansprüche

1. Solaranlage mit mindestens einem fotovoltaischen Solarmodul, welche Anlage durch einen elektrischen Antrieb um wenigstens eine Achse schwenkbar, auf im Tagesablauf maximale Sonneneinstrahlung ausrichtbar ist, **dadurch gekennzeichnet, dass** die Speisung der Schwenkbewegung (O-W) des elektrischen Antriebs (5) einzig durch ein zur Energiegewinnung bestimmtes Solarmodul (11) erfolgt.

2. Solaranlage nach Anspruch 1, **dadurch gekennzeichnet, dass** die Schwenkbewegung (O-W) durch eine Steuerung (50,51;56,57) erfolgt.

3. Solaranlage nach Anspruch 1, **dadurch gekennzeichnet, dass** mehrere Solarmodule (11-14) vorgesehen sind, die in Achsrichtung gesehen, stirnseitig zueinander durch Distanzhalter (16) beabstandet sind und zueinander Luftspalte (17) bilden.

4. Solaranlage nach Anspruch 3, **dadurch gekennzeichnet, dass** die Distanzhalter (16) aus einem Elastomer bestehen und eine Breite von 15-40 mm, bevorzugt 20 mm aufweisen.

5. Solaranlage nach Anspruch 1 oder 3, **dadurch gekennzeichnet, dass** sich die Solarmodule (11-14) oberhalb eines U-förmigen Supports (15) erstrecken, welcher Lager (6a) für eine die Drehachse bildende Welle (6,6') enthält.

6. Solaranlage nach Anspruch 5, **dadurch gekennzeichnet, dass** die Welle (6,6') stationär gehalten ist, dass diese auf einer Endseite ein Zahnrad (21) trägt, um welches ein mit dem Support (15) kraftschlüssig verbundener Antrieb (5) sektoriell und tageszeitabhängig geführt ist.

7. Solaranlage nach Anspruch 5, **dadurch gekennzeichnet, dass** die Solarmudule (11-14) in einem U-förmigen Rahmen seitlich gehalten und zentriert sind.

8. Solaranlage nach Anspruch 5 oder 6, **dadurch gekennzeichnet, dass** an der Welle (6) wenigstens ein Federstab (19) fixiert ist, welcher peripher an einem Rahmen (10) angreift, welcher die Solarmodule (11-14) umfasst.

9. Solaranlage nach Anspruch 1 oder 2, **dadurch gekennzeichnet, dass** die Speisung des Antriebs (5) intervallweise, in zeitlich vorgegebenen Abständen erfolgt, wobei in den zwischen den Intervallen liegenden Zeitabschnitten zumindest der Getriebemotor (33) des Antriebs (5) stromlos geschaltet ist.

10. Solaranlage nach Anspruch 1, **dadurch gekennzeichnet, dass** wenigstens zwei Solarmodule (11,12) vorgesehen sind, wobei das eine Modul (11) den Getriebemotor (33) des Antriebs (5) und das andere ein Schaltglied zur Auskopplung eines Getriebes (32';32,34) von einer feststehenden Welle (6) intermittierend speist.

11. Solaranlage nach Anspruch 8, **dadurch gekennzeichnet, dass** die Welle (6) eine Hohlwelle ist und dass auf dieser wenigstens im unteren Lager (6a) eine kraftschlüssig aufgesetzte Gleitbüchse (6') vorgesehen ist.

12. Solaranlage nach Anspruch 1 oder 9, **dadurch gekennzeichnet, dass** der elektrische Antrieb (5) an einer Stirnseite des Solarpanels (1,1') angeflanscht ist, dass auf der feststehenden Welle (6) ein Zahnrad (21) fixiert ist, welches als Zahnradsegment ausgebildet ist, dass das eine Zahnrad (32') eines Getriebes (32';32,34) in das Zahnrad (21) eingreift, und dass der Getriebemotor (33) im Vorlauf (+Ω) und im Rücklauf (-Ω) den gesamten Antrieb (5) um die Welle (6) um einen Zentriwinkel von wenigstens 90° schrittweise schwenkt.

13. Solaranlage nach Anspruch 12, **dadurch gekennzeichnet, dass** das Getriebe (32';32,34) und der Getriebemotor (33) auf einer Schaltwippe (25,25') montiert und damit vom Zahnradsegment (21) ausrückbar sind.

14. Solaranlage nach Anspruch 13, **dadurch gekennzeichnet, dass** die Schaltwippe (25,25') durch Federn (28,28') in die Richtung des Zahnradsegmentes (21) belastet ist und dass in der Gegenrichtung ein Schaltmagnet (30) vorgesehen ist, der durch seine Ansteuerung die Schaltwippe (25,25') und damit das Antriebszahnrad (32') aus dem Zahnradsegment (21) ausrückt.

15. Solaranlage nach einem der Ansprüche 10, 12 bis 14, **dadurch gekennzeichnet, dass** das Getriebe (32';32,34) ein Stirnradgetriebe ist.

16. Solaranlage nach Anspruch 2, **dadurch gekennzeichnet, dass** bei mehreren benachbarten Solarpanels (1,1') ein zentraler elektrischer Antrieb (5) vorgesehen ist, welcher mechanisch über Treibmittel (56) oder über eine Funkverbindung (50,51) die Schwenkbewegungen der Solarpanels (1,1') miteinander synchronisiert.

17. Verfahren zum Betrieb einer Solaranlage mit mindestens einem fotovoltaischen Solarmodul, welche Anlage durch einen elektrischen Antrieb, welcher einen Getriebemotor enthält, um wenigstens eine Achse schwenkbar, auf im Tagesablauf maximale Sonneneinstrahlung ausrichtbar ist, **dadurch gekennzeichnet, dass** über einen Mikroprozessor (64) ein elektrischer Schwellenwert (US) an einem Solarmodul (11-14) erfasst wird, welcher der morgendlichen und abendlichen Dämmerung entspricht, dass daraus durch einen Zählvorgang die Dauer des Tageslichts erfasst wird, dass dieser Wert im Mikroprozessor (64) gespeichert wird, dass aus den Speicherwerten von mehreren Tagen ein Mittelwert gebildet wird, dass dieser Mittelwert in gleiche Einzelschritte (P1-Pn) aufgeteilt wird, dass die resultierenden Intervalle (P1,P2-Pn) den Getriebemotor (33) mit einem Signal (S1) ansteuern, derart, dass sich die Einzelschritte der Schwenkbewegung über den Tagesablauf wenigstens annähernd gleichmässig verteilen.

18. Verfahren nach Anspruch 17, **dadurch gekennzeichnet, dass** der angesteuerte Getriebemotor (33) durch Positionsgeber (48) und wenigstens einen Positionssensor (49) temporär abgeschaltet wird.

19. Verfahren nach Anspruch 17, **dadurch gekennzeichnet, dass** im Tagesablauf durch ein Solarmodul (11-14) ein Kondensator (40) aufgeladen wird, dass bei der abendlichen Dämmerung, nach einer Unterschreitung der Schwellenwertspannung (US) vom Mikroprozessor (64) ein Steuersignal (S2) an einen Leistungsschalter (68) abgegeben wird und dass dieser die im Kondensator (40) gespeicherte Ladung an das Solenoid eines Schaltmagneten (30) schaltet, welcher durch den resultierenden mechanischen Impuls (J) eine Schaltwippe (25,25') und damit ein Getriebe (32';32',34) aus einem Zahnradsegment (21) kurzzeitig ausrückt.

20. Verfahren nach Anspruch 19, **dadurch gekennzeichnet, dass** ein Solarmodul (11-14) im Tagesablauf den Kondensator (40) über eine Sperrdiode (67) lädt und dessen Leckstrom kompensiert.

21. Verwendung einer Solaranlage nach wenigstens einem der Ansprüche 1 bis 16 zur Speisung von Notstromanlagen mit Batteriepufferung, insbesondere in Verbindung mit Wechselrichtern zur Netzrückspeisung.
